# EUROPEAN PATENT SPECIFICATION

(11) **EP 1 616 339 B1**
(45) Date of publication and mention of the grant of the patent: **18.07.2007**
(21) Application number: 04724667.3
(22) Date of filing: 31.03.2004
(51) Int. Cl.: H01B 11/18

(54) **TRANSMISSION CABLE**
ÜBERTRAGUNGSKABEL
CABLE DE TRANSMISSION

(30) Priority: 09.04.2003 EP 03100953
(43) Date of publication of application: 18.01.2006
(73) Proprietor: Philips Intellectual Property & Standards GmbH, 20099 Hamburg (DE); Koninklijke Philips Electronics N.V., 5621 BA Eindhoven (NL)
(72) Inventor: SCHULZ, Volkmar, c/o Philips IP & standards GmbH, 52066 Aachen (DE)
(74) Representative: Volmer, Georg
(86) International application number: PCT/IB2004/001002
(87) International publication number: WO 2004/090914

(56) References cited:
- US-A- 2 849 693
- US-A- 5 742 165
- US-A1- 2001 032 731
- US-B1- 6 284 971

## Description

The invention relates to a transmission cable. Also, the present invention relates to the field of MRI imaging. In particular, the present invention relates to a transmission cable, an MRI system, an MR-catheter and an RF-coil.

The nuclear resonance phenomenon has been utilized in the past in high resolution magnetic resonance, spectroscopy instruments, and by structural chemists to analyze the structure of chemical compositions. More recently, NMR and MR systems have been developed as medical diagnostic modalities, having applications in imaging the anatomy as well as performing in vivo, non-invasive spectroscopic analyses.

The NMR/MR phenomenon can be excited within a study subject positioned in a homogenous, polarizing magnetic field, having a strength of, for example, 1.5T, by irradiating the object with radio-frequency (RF) energy at the Larmor frequency. In medical diagnostic applications, this is typically accomplished by positioning the patient to be examined in the field of an RF coil, having for example a cylindrical geometry and energizing the RF coil with an RF power amplifier. Upon cessation of the RF excitation, the same or a different RF coil is used to detect the NMR/MR signals emanating from subject volume lying within the field of the RF coil. In the course of a complete NMR/MR scan, pluralities of NMR/MR signals are typically observed. These signals may be used to reconstruct an image or spectroscopic information about the subject studied.

For medical imaging studies, pulsed linear magnetic field gradients may be used to localize the signals to desired areas within the patient to encode spatial information into the signals. In the course of an NMR/MR examination, it is frequently desired to apply pulsed magnetic field gradients in each of the X, Y and Z directions of a conventional Cartesian coordinate system.

Known fixed or optional receiver MR coils such as for example single loop coils, are connected to the NMR/MR scanner via standard coaxial cables. As already mentioned above, it is common to use more than one coil in the NMR/MR system. One problem that may arise in MRI is that due to the use of the standard coaxial cables, the possibility of RF burns to the patient is quite high and increases with the amount of coils/cables being used. Unfortunately, a prediction of parasitic resonances causing the RF burns is usually not possible because of the arrangement of arbitrarily located optional coils, which themselves may have different configurations. Also, different coils may be used for different patients.

Conventionally, bazooka balloons (common mode λ/4-resonators) are used to suppress such local resonances. However, since such bazooka balloons are resonators themselves, they are excitable and may cause that a lot of RF power is dissipated during the transmit pulse.

A conductor adapted to carry high frequency currents is disclosed in US 2 849 693, which comprises two conducting layers separated by insulation, one of said layers being divided transversely into sections. The cable disclosed in this document is not however related to an MR system.

It is the object of the present invention to avoid parasitic resonances in transmission cables.

According to the present invention as set forth in claim 1, the above object may be solved with a transmission cable comprising a first cable segment and a second cable segment, wherein the first cable segment has at least one conductor and wherein the second cable segment has at least one second conductor. The at least one first conductor of the first cable segment is connected to the at least one second conductor of the second cable segment via at least one series impedance.

Advantageously, according to an exemplary embodiment of the present invention, a transmission cable is provided, which may be realized with approximately the same outer dimensions as a conventional coaxial cable, which can be used in the same way as a conventional coaxial cable, but in which almost no parasitic resonance takes place. Furthermore, this transmission cable enables also an AC power transmission. Due to the arrangement according to this exemplary embodiment of the present invention, such a cable improves the patient's security in MR-scanners and this cable is inherently safe for the patient, even if parts of the cable fall off, or even if the cable breaks, since no parasitic resonances occur in the cable. In addition to that, this transmission cable is usable in systems with any field strength.

According to the present invention the transmission cable is realized as a coaxial type cable, where the screen and the inner conductor of segments of the cable are respectively connected to each other by series capacitors. This transmission cable is very simple to handle and can be handled in the same way as a coaxial cable and can be largely used in the same applications as a coaxial cable. Thus, such a transmission cable can be used as a standard cable.

In another exemplary embodiment of the present invention as set forth in claim 2, end portions of the cable are provided with mixers for shifting the frequency of the signal transmitted by the cable. Thus, for example by shifting the frequency of the signal to be transmitted by the cable to a higher frequency, a safe transmission of the signal without adding much noise or distortion can be realized.

Further exemplary embodiments of the transmission cable are set forth in claims 3 and 4.

According to the present invention an MRI system including e.g. the above transmission cable allows for an improved security in MRI-scanner systems by significantly reducing the probability of RF burns to a patient.

It may be seen as the gist of an exemplary embodiment of the present invention that the transmission cable is divided into a huge number of small pieces. The conductors of the small pieces are connected to each other via series capacitors. In case a coaxial cable type cable is realized, those conductors of the cable divided into small pieces are respectively connected by series conductors; e.g. in a coaxial cable the screen and the inner conductor.

These and other aspects of the present invention will become apparent from and elucidated with reference to the embodiments described hereinafter.

Exemplary embodiments of the present invention will be described in the following with reference to the following drawings:
Fig. 1 shows a diagrammatic representation of a general construction of a magnetic resonance imaging apparatus according to an exemplary embodiment of the present invention.
Fig. 2 is a more detailed representation of the measuring volume of the magnetic resonance imaging apparatus show in Fig. 1.
Fig. 3 is a diagrammatic representation of an exemplary embodiment of the transmission cable according to the present invention.

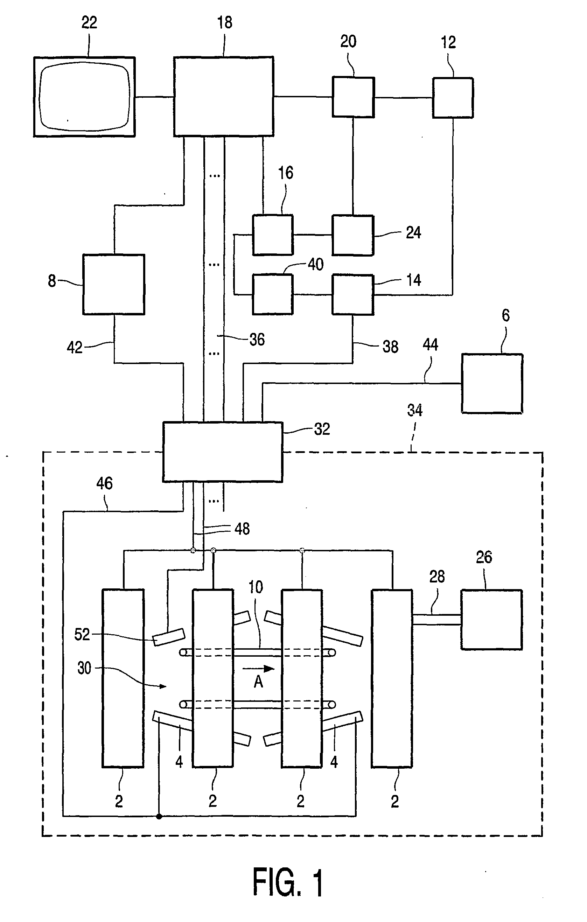

Fig. 1 shows a simplified diagrammatic representation of an exemplary embodiment of a general construction of a magnetic resonance imaging apparatus according to the present invention. The magnetic resonance imaging apparatus depicted in Fig. 1 includes a first magnet system 2. The first magnet system 2 is adapted to generate a uniform, study magnetic field A as indicated with the arrow in Fig. 1. Reference character 4 depicts a second magnet system, which generates magnetic gradient fields. Reference character 6 designates a first power supply source for the first magnet system 2 and reference character 8 designates a second power supply source for the second magnet system 4.

An RF coil 10 is provided to generate a RF magnetic alternating field. The RF coil 10 is connected to a RF transmission device, which includes a RF source 12. The RF coil 10 may furthermore be adapted to be used for the detection of spin resonance signals generated by the RF transmission field in an object to be examined (not shown). For the detection of spin resonance signals generated by the RF transmission field, the RF coil 10 is connected to an RF receiving device, which includes a signal amplifier 40. The output of the signal amplifier 40 is provided to a detector 16.

The detector 16 is connected to a control unit 18. The control unit 18 such as a computer is adapted to control a modulator 20 for operation with the RF source 12. Furthermore, the control unit 18 is adapted to control the first power supply source 8 and a display 22, such as a CRT display for displaying an image reconstructed by the control unit 18.

Furthermore, there is provided a RF oscillator 24 for controlling the modulator 20 and the detector 16, which processes the measuring signals. The forward and return RF signal traffic are separated from each other by a separation circuit 14.

Reference character 26 designates a cooling device arranged to cool the magnet coils of the first magnet system 2 via cooling duct 28. The RF coil 10, which is spatially arranged within the first and second magnet systems 2 and 4 encloses an examination volume 30. In the case of medical MR applications, the examination volume 30 should be large enough to enclose a patient to be examined or at least a part of the patient to be examined, such as the neck or an arm.

By the above arrangement, a steady magnetic field A, gradient fields, which select object slices and a spatially uniform RF alternating field can be generated in the examination volume 30. As already mentioned above, the RF coil 10 may be adapted to be capable of combining the functions of transmitter coils and measuring coils. However, it is also possible to use different coils for these two functions. For example, surface coils may act as measuring coils. The assembly formed by the first magnet system 2, the RF coil 10 and the second magnet system 4 (gradient coils) may be enclosed by an RF shielding Faraday cage 34.

In addition to that, an optional receive MR coil 52 can be provided, which, for example may be a C1-coil.

Reference character 32 designates a feed-through device, connected to the second power supply source 8 by means of a first supply line 42, connected to the separation circuit 14 by means of a RF connection line 38, connected to the first power supply source 6 by means of a second power supply line 42 and connected to the control unit 18 by means of connection leads 36, which are preferably realized as a bundle of cables.

Within the Faraday cage, i.e. within an environment where strong magnetic fields occur, the feed-through device 32 is connected to the second magnet system 4 by means of a first supply cable 46, to the first magnet system by means of a second supply cable 48, which is preferably a bundle of cables, including one cable 48 which is connected to the MR coil 52.

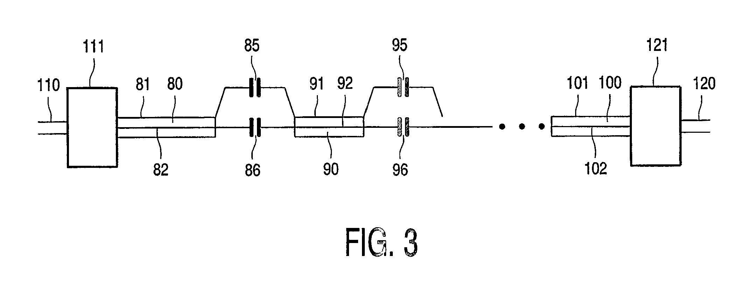

Preferably the cable 48 between the feed-through device 32 and the MR coil 52 is realized with a cable according to the present invention such as the exemplary embodiment of the present invention as shown in Fig. 3. However, it may also be possible to use transmission line according to the present invention in all electrical connections provided within the Faraday cage 34 or within an environment including strong magnetic fields. In other words, each of the first supply cables 46, the second supply cables 48 and each of the connection cables 50 may be realized by one or more cables according to the present invention. Furthermore, it is also possible to use cables according to the present invention as cables for the connection leads 36, the RF connection line 38, the first supply line 42 or the second supply line 40. The cables according to the present invention may also be used for a MR-catheter, which in a variant of this exemplary embodiment, is arranged instead or in addition to the MR coil 52. Thus, an MR cathether and/or an RF coil are provided including a cable according to an exemplary embodiment of the present invention.

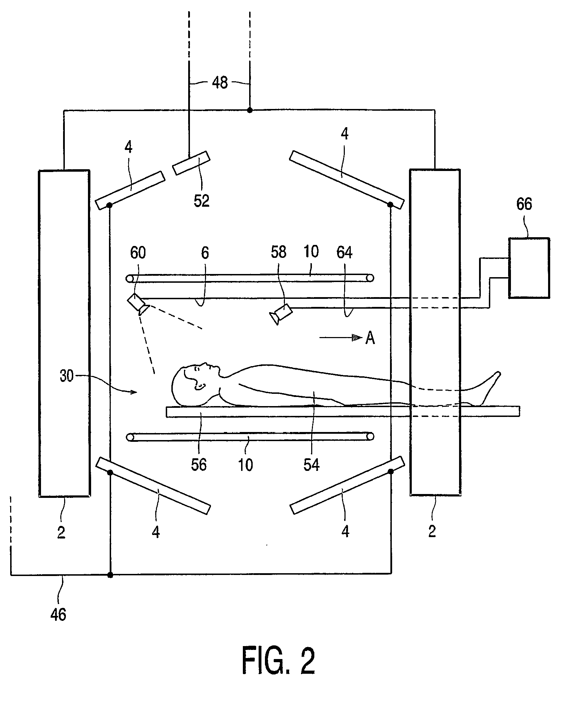

Fig. 2 is a more detailed representation of the examination volume 30 of the MRI apparatus shown in Fig. 1. In order to avoid unnecessary repetition, the same reference characters are used in Fig. 1 to designate the same or corresponding elements in Fig. 2.

In Fig. 2, there is a patient 54 arranged on a patient table 56 within the examination volume 30. Preferably, the patient 54 is arranged such that slice images can be formed of the head and of the neck. Within or in the direct vicinity of the examination volume 30 there is provided electrical connection equipment for maintaining a communication with the patient 54 to be examined. In the exemplary embodiment depicted in Fig. 2, there is provided a camera 58 and a lamp 60. However, other electrical devices necessary or useful for examining the patient 54 may be provided. The camera 58 and the lamp 60 are connected by means of third and fourth supply cables 62 and 64 to a power supply 66. The third and fourth supply cables 62 and 64 may also be used for signal transmission, for example for transmitting an image signal from the camera 58 to the display 22. As already mentioned above, other electrical equipment may be arranged within or near the examination volume 30, for example sensors for measuring the blood pressure of the patient 54, a heart beat or a cerebral activity of the patient 54. Also, there may be provided communication equipment for communication with the patient 54.

Preferably, the third and fourth supply cables 62 and 64 may be realized with the cable according to the present invention, such as the one depicted in Fig. 3.

Fig. 3 is a simplified representation of a transmission cable for transmitting a signal or energy according to an exemplary embodiment of the present invention. The cable depicted in Fig. 3 is a coaxial type cable, consisting of a plurality, preferably a huge number of small cable segments. In Fig. 3 there is shown a first cable segment 80, a second cable segment 90 and a third cable segment 100. Each of the plurality of cable segments 80, 90 and 100, preferably as a length of approximately λ/4. However, the length of the individual cable segments 80, 90 and 100 may be selected differently as long as the length is not λ/2. The first cable segment 80 comprises a first screen 81 and a first inner conductor 82. The second cable segment 90 comprises a second screen 91 and a second inner conductor 92. The third cable segment 100 comprises a third screen 101 and a third inner conductor 102. As may be taken from Fig. 3, these cable segments 80, 90 and 100 are connected via series capacitors 85, 86, 95 and 96 for both conductors of the coax type cables (differential TEM-modes e.g. the screens 81, 91 and 101 and the inner conductors 82, 92 and 102). In detail, the first screen 81 is connected to the second screen 91 with a series capacitor 85 in series and the second screen 91 is connected to the third screen 1 by means of capacitor 95 arranged in series. The first inner conductor 82 is connected to the second inner conductor 92 via a series capacitor 86 and the second inner conductor 92 is connected to the third inner conductor 102 via another series capacitor 96.

At one end of the first cable segment 80, there is provided a first mixer 111, which may be connected to a standard RF port and at one end of the third cable segment 100, there is provided another mixer 121, which may be connected to a coil, such that a coil port 120 is provided.

Preferably, the capacitors 85, 86, 95 and 96 are selected to be in the range of 1 pF. However, the capacity of each capacitor 85, 86, 95 and 96 may also be in the range of 0.5 pF to 2 pF. According to an aspect of the present invention, the capacitances should be realized from impedances of approximately 500Ω, such that a capacitance of approximately 2.5 pF is realized at 64 MHz. In case the cable is to be used in MRI systems having a higher field strength, these impedances should be varied. E.g. for 128 MHz, a maximum of 1 pF should be selected. For 32 MHz, a maximum of 4-5 pF should be selected.

In applications in MR-scanners, each capacitor 85, 86, 95 and 96 is preferably chosen to be in the range of 1 pF in order to keep local resonances as high as possible. Due to this, at a MR frequency (fᵣ), the cable depicted in Fig. 3 is completely off resonant, such that there is no possibility for local hot spots, i.e. parasitic resonances, which may cause RF burns e.g. to a patient during the transmitter pulse of the MR-scanner. Thus, the transmission coefficient S₂₁ of the transmission matrix S is very low at the MR frequency fᵣ. As depicted in Fig. 3, for MR signal and/or power transmission, the mixers 111 and 121 may be provided for shifting a signal to be transmitted via the cable to a higher frequency such as for example 10 × fᵣ. Due to this, the whole two-port system, i.e. from the standard RF port 110 to the coil port 120, acts as a simple but safe coaxial cable and can be connected to any system allowing for an interchangeability of the cable.

Instead of the capacitors 85, 86, 95 and 96, according to an aspect of the present invention, inductivities may be provided. These inductivities may be in the range of 5 nH (for 64 MHz) to 10 nH. Advantageously, this allows for the transmission of a direct current. The frequency conversion should then be in the range of a few MHz, such as e.g. 2 MHz.

Due to the above arrangement, a cable is provided which is inherently safe for the patient, even if, for example, the cable breaks. Also, the arrangement shown in Fig. 3 allows for a very slim arrangement of the cable, such that the cable may have the same dimensions as for example a conventional coaxial cable. Furthermore, the arrangement of Fig. 3 may be used in combination with a conventional coaxial cable and can be adapted to a standard cable system. Furthermore, as already indicated above, the transmission cable shown in Fig. 3 may be used for AC power transmission. Also, the transmission cable according to the exemplary embodiment depicted in Fig. 3 is usable in MR systems with any field strength or may easily be adapted to any field strength. Instead of the arrangement depicted in Fig. 3 having only two conductors, a multi-conductor system may also be used for implementing the present invention.

Apart from a coaxial type cable, the present invention can be implemented in any kind of transmission cable. Cables having a plurality of conductors may be realized in accordance with the present invention. Also, simple two wire connection cables can be implemented in accordance with the present invention.

Also, according to an aspect of the present invention, instead of the capacitors as shown in Fig. 3, parallel or serial resonant circuits may be used.

Apart from being used in MR / NMR applications, the transmission cable according to the present invention may also be used in other environments with strong magnetic fields such as, for example, adjacent to electric machines. Also, the cable according to the present invention may be used for a MR-catheter, RF coil or MR coil.

## Claims

1. MR system with a transmission cable, the transmission cable comprising:
a first cable segment (80) and a second cable segment (90),
wherein the first cable segment (80) has at least one first conductor and wherein the second cable segment (90) has at least one second conductor;
wherein the at least one first conductor of the first cable segment is connected to the at least one second conductor of the second cable segment via at least one series impedance,
wherein the transmission cable is a coaxial type cable including the first and second cable segments;
wherein the at least one first conductor includes a first screen (81) and a first inner conductor (82);
wherein the at least one second conductor includes a second screen (91) and a second inner conductor (92);
wherein the first screen (81) is connected to the second screen (91) by means of a series capacitor (85) of the at least one series impedance; **characterized in that**
the first inner conductor (82) is connected to the second inner conductor (92) by means of another series capacitor (86) of the at least one series impedance.

2. The MR system of claim 1, wherein the cable has a first end and a second end, wherein each of the first and second ends is provided with a mixer for shifting a frequency of the signal transmitted by the cable.

3. The MR system of claim 1, wherein the at least one series impedance includes a capacitor with a capacity in the range of 1 pF

4. The MR system of claim 1, wherein the at least one series impedance includes an inductor with an inductance in the range of 10 nH.

## Patentansprüche

1. MR-System mit einem Übertragungskabel, wobei das Übertragungskabel Folgendes umfasst:
ein erstes Kabelsegment (80) und ein zweites Kabelsegment (90),
wobei das erste Kabelsegment (80) mindestens einen ersten Leiter hat und wobei das zweite Kabelsegment (90) mindestens einen zweiten Leiter hat;
wobei der mindestens eine erste Leiter des ersten Kabelsegments über mindestens eine Reihenimpedanz mit dem mindestens einen zweiten Leiter des zweiten Kabelsegments verbunden ist,
wobei das Übertragungskabel ein Kabel vom koaxialen Typ ist, das das erste und das zweite Kabelsegment umfasst;
wobei der mindestens eine erste Leiter eine erste Schirmung (81) und einen ersten Innenleiter (82) umfasst;
wobei der mindestens eine zweite Leiter eine zweite Schirmung (91) und einen zweiten Innenleiter (92) umfasst;
wobei die erste Schirmung (81) über einen Reihenkondensator (85) von der mindestens einen Reihenimpedanz mit der zweiten Schirmung (91) verbunden ist; **dadurch gekennzeichnet, dass** der erste Innenleiter (82) über einen weiteren Reihenkondensator (86) von der mindestens einen Reihenimpedanz mit dem zweiten Innenleiter (92) verbunden ist.

2. MR-System nach Anspruch 1, wobei das Kabel ein erstes Ende und ein zweites Ende hat, wobei sowohl das erste als auch das zweite Ende mit einer Mischeinheit versehen ist, um eine Frequenz des über das Kabel übertragenen Signals zu verschieben.

3. MR-System nach Anspruch 1, wobei die mindestens eine Reihenimpedanz einen Kondensator mit einer Kapazität im Bereich von 1 pF umfasst.

4. MR-System nach Anspruch 1, wobei die mindestens eine Reihenimpedanz einen Induktor mit einer Induktivität im Bereich von 10 nH umfasst.

## Revendications

1. Système MR avec un câble de transmission, le câble de transmission comprenant :
un premier segment de câble (80) et un second segment de câble (90),
où le premier segment de câble (80) possède au moins un premier conducteur et où le second segment de câble (90) possède au moins un second conducteur ;
où le au moins un premier conducteur du premier segment de câble est connecté audit au moins un second conducteur du second segment de câble via au moins une impédance série,
où le câble de transmission est un câble de type coaxial comprenant les premier et second segments de câble ;
où le au moins un premier conducteur comprend un premier blindage (81) et un premier conducteur interne (82) ;
où le au moins un second conducteur comprend un second blindage (91) et un second conducteur interne (92) ;
où le premier blindage (81) est connecté au second blindage (91) au moyen d'un condensateur série (85) de la au moins une impédance série; **caractérisé en ce que** le premier conducteur interne (82) est connecté au second conducteur interne (92) au moyen d'un autre condensateur série (86) de la au moins une impédance série.

2. Système MR selon la revendication 1, dans lequel le câble possède une première extrémité et une seconde extrémité, où chacune des première et seconde extrémités est pourvue d'un changeur de fréquence pour déplacer une fréquence du signal transmis par le câble.

3. Système MR selon la revendication 1, dans lequel la au moins une impédance série comprend un condensateur avec une capacité dans la gamme de 1 pF.

4. Système MR selon la revendication 1, dans lequel la au moins une impédance série comprend une bobine d'inductance avec une inductance dans la gamme de 10 nH.
